# EUROPEAN PATENT APPLICATION

(11) **EP 4 832 350 A1**
(43) Date of publication of application: **28.10.2026**
(21) Application number: 26168483.1
(22) Date of filing: 27.03.2026
(51) Int. Cl.: H03M 1/08, H03F 1/30, H03M 3/00

(54) **ADC WITH AMPLIFIER STAGE HAVING A CONTROLLABLE BIAS CURRENT BASED ON DAC CURRENT**

(30) Priority: 21.04.2025 IN 202541038115
(71) Applicant: NXP B.V., 5656 AG Eindhoven (NL)
(72) Inventor: Vyas, Bhargav Rajendra, 5656AG Eindhoven (NL)
(74) Representative: Schwarzweller, Thomas

(57) **Abstract**

An analog to digital converter (ADC) circuit includes a plurality of amplifier stages coupled in series. A last in series amplifier stage includes a bias current source whose current is controlled based on a magnitude of a current output of a digital to analog converter (DAC) that provides an analog feedback signal for producing an error signal that is received by a first in stage of the plurality of amplifier stages. An earlier in series amplifier stage includes a bias current source whose current is characterized as a Proportional-to-Absolute Temperature (PTAT) current.

## Description

### BACKGROUND OF THE INVENTION

### Field of the Invention

This invention relates to an analog to digital converter (ADC) circuit with a plurality of amplifier stages coupled in in series.

### Background

Delta sigma modulators may be utilized in converting analog signals to digital signals. Such modulators may include a series of amplifier stages.

### Brief Description of the Drawings

The present invention may be better understood, and its numerous objects, features, and advantages made apparent to those skilled in the art by referencing the accompanying drawings.
Figure 1 is a block diagram of an ADC circuit according to one embodiment of the present invention.
Figure 2 is a block diagram of multiple amplifier stages according to one embodiment of the present invention.
Figure 3 is a block diagram of multiple amplifier stages according to one embodiment of the present invention.
Figure 4 is a circuit diagram of an amplifier stage according to one embodiment of the present invention.
Figure 5 is a circuit diagram of a current control circuit according to one embodiment of the present invention.
Figure 6 is a circuit diagram of a current control circuit according to one embodiment of the present invention.
Figure 7 is a circuit diagram of a PTAT current control circuit according to one embodiment of the present invention.
Figure 8 is a block diagram of an ADC circuit according to one embodiment of the present invention.

The use of the same reference symbols in different drawings indicates identical items unless otherwise noted. The Figures are not necessarily drawn to scale.

### DETAILED DESCRIPTION

The following sets forth a detailed description of a mode for carrying out the invention. The description is intended to be illustrative of the invention and should not be taken to be limiting.

As disclosed herein, an analog to digital converter (ADC) circuit includes a plurality of amplifier stages coupled in series. A last in series amplifier stage includes a bias current source whose current is controlled based on a magnitude of a current output of a digital to analog converter (DAC) that provides an analog feedback signal for producing an error signal that is received by a first in stage of the plurality of amplifier stages. An earlier in series amplifier stage includes a bias current source whose current is characterized as a Proportional-to-Absolute Temperature (PTAT) current.

In an ADC circuit such as an ADC circuit implementing a continuous time delta sigma modulator filter network, DAC current is provided as feedback into the network for producing an error signal that is provided to amplifier stages coupled in series of the network. Typically, bias current sources of the amplifier stages are configured to provide a PTAT current for constant trans-conductance (gm). Because the last in series amplifier stage typically drives the output of the amplifier stages coupled in series including for providing feedback to the input of the amplifier stages, a PTAT bias current for the last in series amplifier stage may be insufficient at cold temperature corner areas of operation. In such situations, the magnitude of the analog feedback DAC current would remain at a high level relative to the PTAT bias current. Accordingly, the slew of the output of the last in series amplifier stage may be unable to maintain signal and Q-noise feedback. In addition, process variation in the DAC circuit devices may not be sufficiently accounted when utilizing a PTAT bias current for the last in series amplifier stage, thereby leading to nonoptimal amplifier performance.

Accordingly, providing a last in series amplifier stage with a bias current that is controlled based on the magnitude of the feedback DAC current may provide for an ADC circuit where the last in series amplifier stage has sufficient current for cold temperature corner areas of operation to maintain the signal and Q-noise feedback, thereby maintaining the signal-to-quantization noise ratio and minimizing distortion. In addition, the bias current of the last in series amplifier stage can be adjusted to compensate for process variation in the DAC circuit devices.

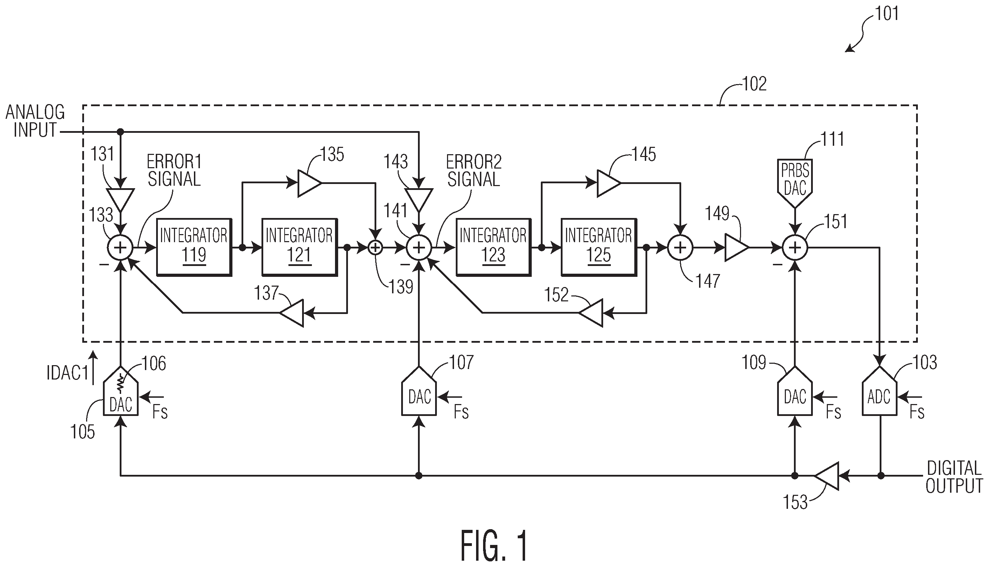

Figure 1 is a circuit diagram of an ADC circuit 101 according to one embodiment. Circuit 101 includes an ANALOG INPUT to receive an analog signal and a DIGITAL OUTPUT to provide a digital signal representative of the analog signal. The digital signal is produced by ADC 103. In the embodiment shown, the input signal to ADC 103 is produced by a delta sigma modulator filter network 102 that receives digital feedback signals from DACs 105, 107, and 109 and receives a Pseudo-Random Binary Sequence (PRBS) analog signal from DAC 111. In some embodiments, the digital output signal of ADC 103 is a single bit signal but may be a multi-bit signal in other embodiments.

In the embodiment shown, the delta sigma modulator filter network 102 is a fourth order delta sigma modulator filter network that includes four integrators 119, 121, 123, 125. Network filter 102 includes feedforward circuits 131 and 143 that are connected to the ANALOG INPUT to receive the input analog signal. The output of feedforward circuit 131 is connected to an input of a combiner circuit 133. Combiner circuit 133 includes another input to receive the analog feedback signal of DAC 105. In the embodiment shown, the combiner circuit 133 includes an input that is coupled to the output of the feedback circuit 137. The input of feedback circuit 137 is connected to the output of integrator 121. The output of combiner circuit 133 is connected to the input of integrator 119 to provide an ERROR1 SIGNAL to the input of integrator 119. Combiner circuit 133 produces the ERROR1 SIGNAL by subtracting the analog feedback signal produced by the output of DAC 105 from the analog input signal and the output of feed forward circuit 137.

The output of integrator 119 is connected to the input of integrator 121 and to the input of feedforward circuit 135. The output of feedforward circuit 135 is connected to an input of combiner circuit 139. The output of integrator 121 is also connected to an input of combiner circuit 139. The output of combiner circuit 139 is connected to an input of combiner circuit 141, and the output of feed forward circuit 143 is connected to an input of combiner circuit 141. The output of DAC 107 is connected to an input of combiner circuit 141, and the output of feedback circuit 152 is connected to an input of combiner circuit 141. Combiner circuit 141 subtracts the analog feedback signal produced by DAC 107 from the output of feed forward circuit 143, the output of feedback circuit 152, and the output of combiner circuit 139 to produce an ERROR2 SIGNAL.

Integrator 123 includes an input to receive the ERROR2 SIGNAL from combiner circuit 141. The output of integrator circuit 123 is connected to the input of integrator 125 and also connected to the input of feed forward circuit 145. The output of integrator 125 is connected to the input of feedback circuit 153 and to the input of combiner circuit 147. Combiner circuit 147 also includes another input that is connected to the output of feedforward circuit 145. The output of combiner circuit 147 is connected to the input of gain circuit 149. In some embodiments, gain circuit 149 is a transistor pair gain circuit, but may be another type of gain circuit in other embodiments. The output of gain circuit 149 is connected to an input of combiner circuit 151. Combiner circuit 151 also includes an input connected to DAC 111 and another input connected to DAC 109. Combiner circuit 151 subtracts the analog feedback signal produced by DAC 109 from the output of gain circuit 149 and the output of DAC 111. The output of combiner circuit 151 is connected to the input of ADC 103.

The output of ADC 103 is connected to feedback circuit 153. The output of feedback circuit 153 is connected to the inputs of DACs 105, 107, and 109. DACs 105, 107, 109, and 111 and ADC 103 each receive a frequency clock signal (FS) where the operations of these circuits are timed according to the clock signal. In some embodiments, ADC 103 is sampled the rising edge of the clock signal (FS) and DACs 105, 107, and 109 are sampled on the falling edge of the clock signal to implement half-cycle feedback.

In some embodiments, feed forward circuits 131, 135, 143, 145 and feedback circuits 137, 152, and 153 are implemented with resistive circuits of various resistive values but may be implemented with other circuitry in other embodiments.

During operation, filter network 102 performs delta sigma modulation on the input analog signal and the feedback analog signals from DACs 105, 107, and 109 to produce the analog signal that is provided to the input of ADC 103.

In some embodiments, the direction of the current provided by the outputs of DACs 105, 107, and 109 to combiner circuits 133, 141, and 151, respectively, is dependent upon the digital output from ADC 103. For example, current IDAC1 produced by DAC 105 is in a positive direction (as shown by the arrow in Figure 1) when the output of ADC 103 indicates a "1" value and in a negative direction when the output of ADC 103 indicates a "0" value. In some embodiments, DACs 105, 107, and 109 each include a resistor (with resistor 106 for DAC 105 shown in Figure 1) and two transistors (not shown). During operation, one of the transistors is conductive to provide a path from a VDD voltage source through the resistor (e.g.,106) to the output of the DAC when the output of ADC 103 represents a "1" value. The other transistor is conductive to provide a path from a VSS voltage source through the resistor to the output of the DAC when the output of ADC 103 represents a "0" value. In some embodiments, the DACs may also include flip flops (not shown) and latches (not shown) for controlling the timing of the control signals to the transistors based on the output of ADC 103. However, the DACs may have different configurations, different circuitry, and/or operate in a different manner in other embodiments.

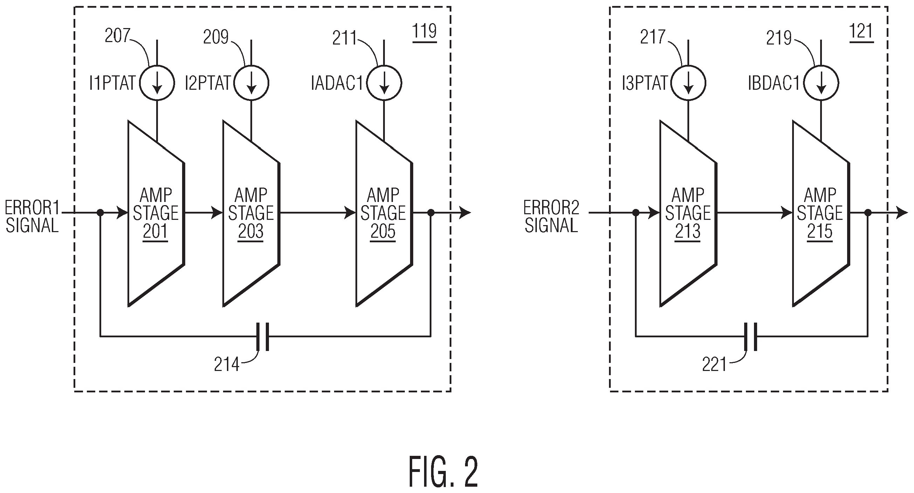

Each of integrator 119, integrator 121, integrator 123, and integrator 125, includes multiple amplifier stages coupled in series. For example, Figure 2 shows a circuit diagram of an embodiment of integrator 119 and integrator 121. Integrator 119 includes three amplifier stages 201, 203, and 205 coupled in series. Stage 201 includes an input to receive the ERROR1 SIGNAL. The output of stage 201 is connected to the input of stage 203. The output of stage 203 is connected to the input of stage 205. Integrator 119 includes a feedback capacitor 214 for capacitively coupling the output of stage 205 to the input of stage 201.

Integrator 121 that includes two amplifier stages 213 and 215 coupled in series. The input of amplifier stage 213 is coupled to receive the ERROR2 SIGNAL. The output of amplifier stage 213 is connected to the input of amplifier stage 215. Integrator 121 includes a feedback capacitor 221 for capacitively coupling the output of amplifier stage 215 to the input of amplifier stage 213.

The amplifier stages of integrators 119 and 121 are each coupled in series such that an output of a proceeding amplifier stage in the series is coupled to an input of a following stage in the series such that a signal is propagated along the stages in the series. Stage 201 is the first in series stage and stage 205 is the last in series stage for the series of stages for integrator 119. Stage 213 is the first in series stage and stage 215 is the last in series stage for the series of stages for integrator 121. In the embodiment of Figure, the amplifier stages are single ended amplifier stages.

As shown in Figure 2, each amplifier stage of stages 201, 203, 205, 213, and 215, includes a bias current source of bias current sources 207, 209, 211, 217, and 219, respectively. In the embodiment of Figure 2, the currents produced by bias current source 207 of stage 201, bias current source 209 of stage 203, and bias current source 217 of stage 213 are characterized as IPAT currents in that they vary proportionally to absolute temperature.

The bias current sources 211 and 219 for the last in series stages 205 and 215, respectively, are controlled based on a magnitude of the current output of DAC 105 of Figure 1. In some embodiments, the current of a DAC 105 may change due to process, temperature, or voltage conditions. These changing conditions may affect the ERROR1 SIGNAL and the ERROR2 SIGNAL.

Because the output of the last in series stage 205 is coupled to the input of stage 201 through capacitor 214 and the output of the last in series stage 215 is coupled to the combiner circuit 133 through feed forward circuit 137 (See Figure 1), the output of these stages is configured to affect the ERROR1 SIGNAL. Because the bias current sources of these stages are controlled based on the current output of DAC 105, the last in series stages are capable of providing more current or less current in response to a change in magnitude of the current provided by the output of DAC 105 to combiner circuit 133, thereby ensuring a proper operation of the filter network.

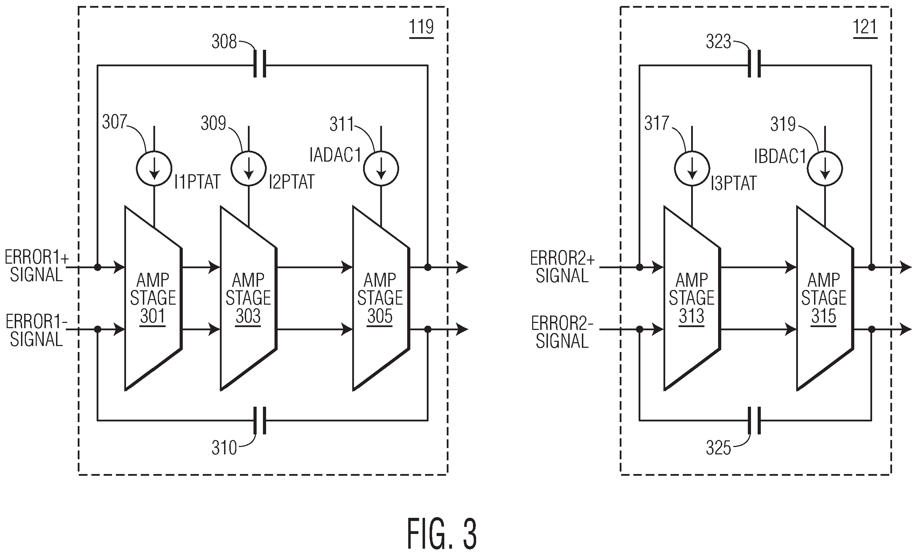

Figure 3 is an alternative embodiment of integrators 119 and 121 where amplifier stages 301, 303, 305, 313, and 315 are differential signal amplifier stages, where each amplifier stage includes a differential input and a differential output. Amplifier stages 301, 303, 305, 313, and 315 include bias current sources 307, 309, 311, 317, and 319, respectively, to provide bias currents I1PTAT, I2PTAT, IADAC1, I3PTAT, and IBDAC1, respectively. As shown in Figure 3, stage 301 receives a differential error signal of the ERROR SIGNAL+ and the ERROR SIGNAL-. In the embodiment of Figure 3, the differential output of the preceding amplifier stage is provided to the differential input of a successive amplifier stage in a series of amplifier stages of an integrator.

Integrator 119 of Figure 3 includes feedback capacitors 308 and 310 that are each connected to a differential output of amplifier stage 305 and a differential input of amplifier stage 301. Integrator 121 of Figure 3 includes feedback capacitors 323 and 325 that are each connected to a differential output of amplifier stage 315 and a differential input of amplifier stage 313.

Other embodiments of Figure 2 and Figure 3 may include a different number of amplifier stages coupled in series. For example, integrator 119 may include four stages and integrator 121 may include three stages. Also, in some embodiments, integrator 119 may have the same number of stages as integrator 121. In other embodiments, integrator 121 may have more stages than integrator 119. In other embodiments, the integrators may include different circuitry and/or have a different configuration. Referring to Figure 1, integrators 123 and 125 may have similar configurations to integrators 119 and 121 as shown in the embodiment of Figure 2 or in the embodiment of Figure 3.

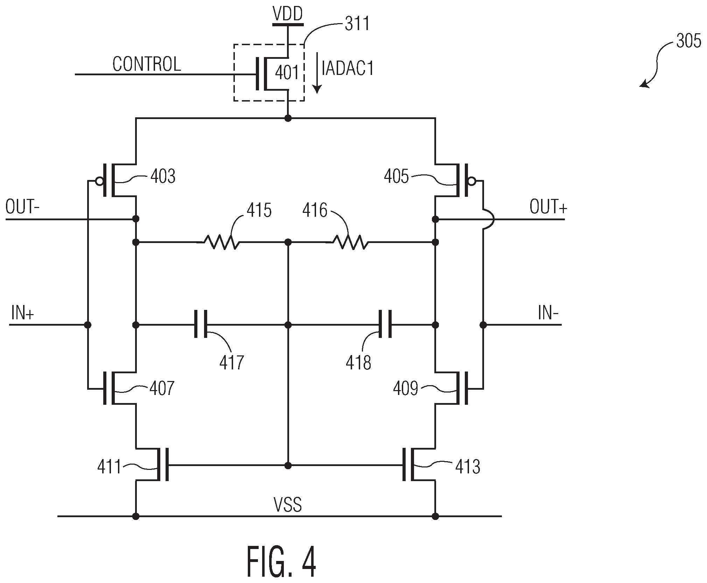

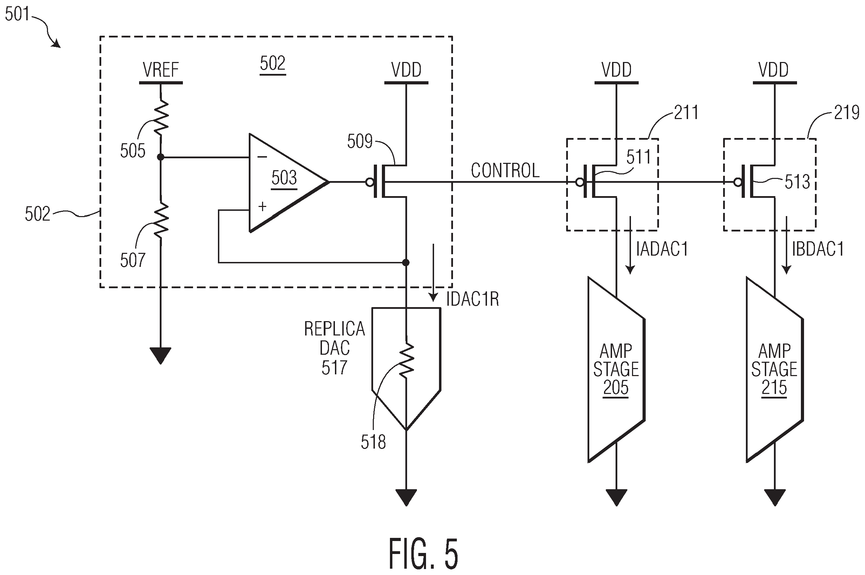

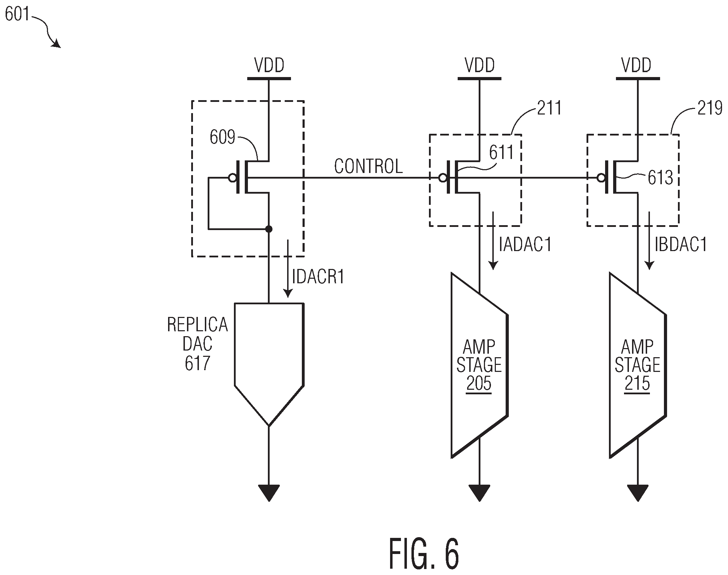

Figure 4 is a circuit diagram of amplifier stage 305 according to one embodiment of the present invention. In the embodiment shown, amplifier stage 301 is a differential amplifier stage in that it receives a differential input signal of IN+ and IN- and provides a differential output signal of OUT+ and OUT-. In the embodiment shown, bias current source 311 of amplifier stage 305 is implemented with an NFET 401 whose drain is connected to VDD voltage supply rail. The gate of NFET 401 is coupled to receive a CONTROL signal from a current control circuit (see the embodiments of Figures 5 and 6 as described below) for controlling the bias current IADAC1 based on the magnitude of the output current by DAC 105.

Amplifier stage 305 includes two branches coupled between the source of NFET 401 and supply voltage rail VSS. A first branch includes input PFET 403 and input NFET 407, each of whose gates are coupled to receive the IN+ signal. The first branch also includes NFET 411, whose source is connected to supply voltage rail VSS and whose drain in connected the source of NFET 407. The first branch includes an output node connected to the drain of PFET 403 and the drain of NFET 407 that provides the OUT- signal. A second branch includes input PFET 405 and input NFET 409, each of whose gates are coupled to receive the IN- signal. The second branch also includes NFET 413, whose source is connected to supply voltage rail VSS and whose drain in connected the source of NFET 409. The second branch includes an output node connected to the drain of PFET 405 and the drain of NFET 409 that provides the OUT+ signal.

Amplifier stage 305 includes a gain compensation circuit connected between the differential output nodes (OUT- and OUT+). The gain compensation circuit sets the gain for amplifier stage 305. The gain compensation circuit includes resistors 415 and 416 and capacitors 417 and 418. Resistors 415 and 416 and capacitors 417 and 418 also establish a common output and provide stability of the common mode loop in concert with NFETs 411 and 413.

NFETs 411 and 413 serve as common mode feedback transistors whose gates are both connected to a terminal of resistor 415, a terminal of resistor 416, an electrode of capacitor 417, and an electrode of capacitor 418.

During operation, if the IN+ signal is at a high voltage and the IN- signal is at a low voltage, the current from bias current source 311 is steered through a conductive PFET 405 to the output node OUT+ which pulls the voltage of output node OUT+ high. A conductive NFET 407 acts to pull the voltage of the output node OUT- low. If the IN- signal is at a high voltage and the IN+ signal is at a low voltage, the current from current source 311 is steered through a conductive PFET 403 to output node OUT- which pulls the voltage of output node OUT- high. A conductive transistor 409 acts to pull the voltage of the output node OUT+ low.

During operating conditions where a PTAT bias current may be inadequate for proper operation, the drive current at output node OUT+ or at output node OUT- may be insufficient to drive circuitry connected to the output stage, thereby negatively impacting the performance of the ADC circuit. For example, as explain earlier, the last in series amplifier stage output current may be insufficient to properly adjust the error signal due to increased current from the output of DAC 105. Accordingly, providing an amplifier stage where the bias current can be adjusted during conditions such as cold temperature corner condition, may provide for an ADC circuit that can maintain operational efficiency during such conditions.

In the embodiment shown, amplifier stage 305 is a transconductance amplifier (OTA) stage. However, amplifier stage 305 may be another type of amplifier stage in other embodiments. Furthermore, amplifier stage 305 may have other configurations, include other types of transistors (e.g. bipolar), may be single ended (e.g. as with the amplifier stages of Figure 2), and/or may include other circuitry (e.g. diodes, voltage gain output stages) in other embodiments. For example, an amplifier stage may include a bias current source (not shown) that is connected to voltage supply rail VSS and connected to the sources of NFETs 411 and 413 in addition to/or in place of current source 311. The bias current of such a bias current source would receive a control signal and would be controlled based on the magnitude of the DAC output current.

Figure 5 is a circuit diagram of a current control circuit 501 for controlling bias currents IADAC and IBDAC provided to amplifier stages 205 and 215, respectively, based on the magnitude of the output current of DAC 105. In the embodiment shown, circuit 501 includes a replica DAC 517 for simulating the magnitude of the output current of DAC 105. In some embodiments, Replica DAC 517 includes a resistor 518 that is of the same size and type as resistor 106 of DAC 105. In other embodiments, resistor 518 is the same type as resistor 106 of DAC 105. Thus, as the output current IDAC1 of DAC105 changes due to changing operating conditions or changes over time due to process variations, the current IDAC1R through replica DAC 517 changes accordingly. In embodiments where the ADC circuit is a differential circuit, resistor 518 of replica DAC 517 would be the same size and type as both resistors of the differential DAC outputs of a differential DAC (not shown). In some embodiments, replica DAC 517 may include other circuitry included in DAC 105 such as closed switches which may be found in DAC 105 to simulate the magnitude of the current of DAC 105. In some embodiments, replica DAC 517 simulates a current that is a match or near match of the magnitude of the DAC output current. However, in other embodiments, the simulated current may be proportional (or nearly proportional) at a non 1.0 ratio to the magnitude of the DAC output current.

Circuit 501 includes a voltage to current converter circuit 502. Circuit 502 includes an amplifier 503 and a voltage divider implemented with resistors 505 and 507. The output of amplifier 503 produces the CONTROL signal. The voltage divider includes a node to provide a reduced voltage of reference voltage VREF to the inverting input of amplifier 503. Circuit 502 includes a PFET 509 whose gate is connected to the output of amplifier 503 and whose drain is connected to the noninverting input of amplifier 503. The source of PFET 509 is connected to supply voltage rail VDD. Circuit 502 controls current the current through DAC 105 (IDAC1) such that the voltage at the drain of PFET 509 matches the voltage at the inverting input of amplifier 503.

During operation, as the current through replica DAC 517 (IDAC1R) increases (simulating the magnitude of the output current of DAC 105), the voltage of the noninverting node of amplifier 503 decreases. In response, amplifier 503 decreases the voltage at its output (CONTROL) to increase the current through PFET 509 to pull up the voltage of the noninverting input of amplifier 503 to match the voltage of the inverting input of amplifier 503.

As shown in Figure 5, current sources 211 and 219 are implemented with PFETs 511 and 513, respectively. The gates of PFETs 511 and 513 are connected to the output of amplifier 503 to receive the CONTROL SIGNAL in a current mirror configuration with PFET 509. As the current through replica DAC 517 changes, the current provided by current sources 211 and 219 (IADAC1 and IBDAC1, respectively) change as well such that the current provided by current sources 211 and 219 are both positively correlated and are proportional to IDAC1R. In some embodiments, currents IADAC1 and IBDAC1 are the same, but in other embodiments, they may be at different ratios to each other. In some embodiments, currents IADAC1 and IBDAC1 are proportional to IDAC1R at a ratio below 1.0, at 1.0, or above 1.0 (> 1.0) in some embodiments, depending upon the sizes of PFETs 509, 511, and 513.

Figure 6 is a circuit diagram of a current control circuit 601 according to another embodiment, for controlling bias currents IADAC and IBDAC provided to amplifier stages 205 and 215, respectively, based on the magnitude of the output current of DAC 105. In the embodiment shown, circuit 601 includes a replica DAC 617 for simulating the magnitude of the output current of DAC 105 similar to replica DAC 517 of Figure 5.

Circuit 601 includes a PFET 609 in a diode configuration with its source connected to the VDD supply voltage rail and its gate and drain connected together and to a current path of replica DAC 617. The drain and gate of PFET 609 are connected to the gates of PFETs 611 and 631 in a current mirror configuration to provide the CONTROL signal.

If the current through replica DAC 617 (IDACR1) increases, the voltage at the drain of PFET 609 will drop, which decreases the voltage at its gate (CONTROL signal) thereby increasing the current through PFET 609 to pull up the voltage of its drain such that the source-drain voltage drop of PFET 609 remains at a constant diode drop (e.g., .3.5 V). Accordingly, the current produced by PFETs 611 and 613 will increase accordingly. As such, the increase in currents IADAC1 and IBDAC1 are positive correlated and proportional to current IDACR1.

Although Figures 5 and 6 set forth two embodiments for generating the control signal for controlling the bias current of the last in series amplifier stages based on a magnitude of the DAC current, other circuits may have other configurations, function in different ways, and/or include other circuitry.

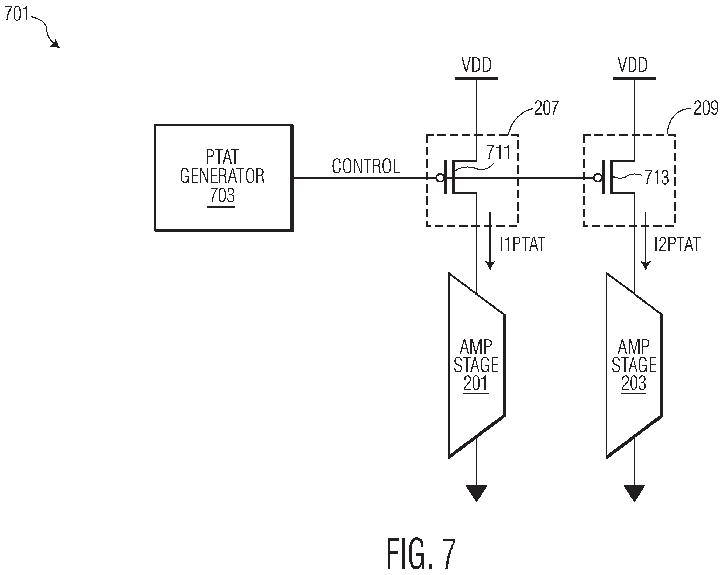

Figure 7 is a circuit diagram for controlling the current provided by PTAT bias current sources 207 and 209 of amplifier stages 201 and 203, respectively. In the embodiment show, current source 207 is implemented with NFET 711 and current source 209 is implemented with NFET 713. The gates of NFETs 711 and 713 are controlled by an output of PTAT current generator 703 which provides a CONTROL SIGNAL that makes currents I1PTAT and I2PTAT proportional to absolute temperature. The other IPTAT current sources of ADC circuit 101 may also be controlled by the CONTROL signal as well. Other embodiments may include other types of PTAT current sources.

Referring back to Figure 1, an ADC circuit may have other configurations including having a different number of integrators (2^{nd} order, 3^{rd} order, 5^{th} order etc.) and a different number of feedback DACs. In some embodiments, an ADC circuit may have only one integrator. Also, an ADC circuit may have other circuitry including feed forward and feedback capacitor paths as well a different arrangement of feed forward and feedback circuits.

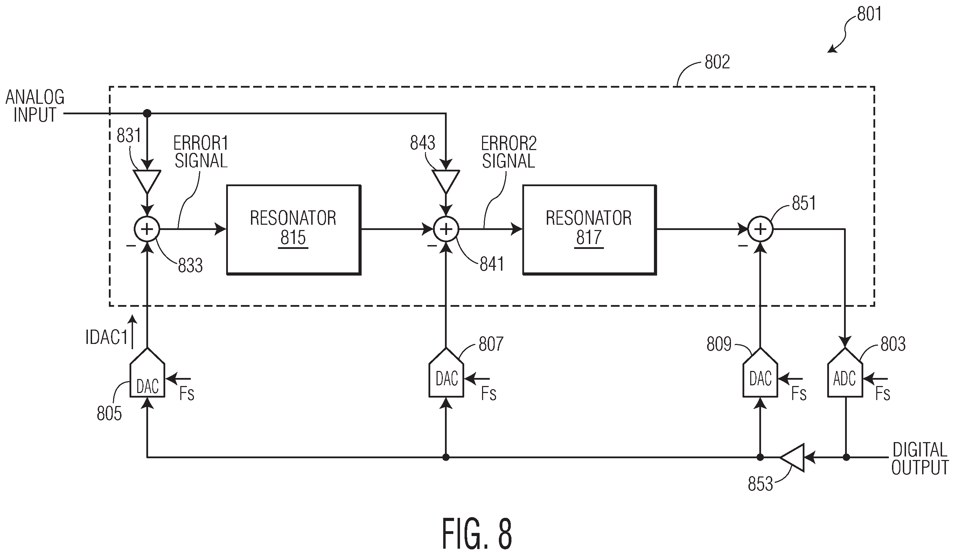

Figure 8 is a circuit diagram of another embodiment of an ADC circuit 801. Circuit 801 includes an ANALOG INPUT for receiving an analog signal and a DIGITAL OUTPUT for providing a digital signal that is indicative of the analog signal. Circuit 801 includes a sigma delta modulator filter network 802 that includes two resonators 815 and 817, combiner circuit 833, 841, and 851, and feedforward circuits 831 and 843. Circuit 801includes DACs 805, 807, and 809 for providing signals that are analog representations of the digital signal provided at the DIGITAL OUTPUT from ADC 803. Each DAC provides an output current to a respective combiner circuit whose polarity depends on whether a logical "1" or a logical "0" is provided at the output of ADC 803. Circuit 801 also includes feedback circuit 853. DACs 805, 807, 809, and 803 each include and input to receive a clock signal FS for controlling the timing of the operation of these circuits.

Resonator 815 receives an ERROR1 SIGNAL from combiner circuit 833, which subtracts the output of DAC 805 from the output of feedforward circuit 831 to produce the ERROR1 SIGNAL. Resonator 815 produces an output that is provided to combiner circuit 841. Combiner circuit 841 subtracts the output of DAC 807 from the output of resonator 815 and from the output of feed forward circuit 843 to produce the ERROR2 SIGNAL. The output of resonator 817 is provided to combiner circuit 851 which subtracts the output of DAC 809 from the output of resonator 817 to provide an analog input signal to ADC 803.

Resonators 815 and 817 each include a series of amplifier stages coupled in series similar to the series of amplifier stages shown in Figure 2 for single ended embodiments or the amplifier stages shown in Figure 3 for differential embodiments. The bias current source of the last in series amplifier stage of resonator 815 is controlled based on the magnitude of the current output of IDAC1 produced by the output of DAC 805. The bias current source of the last in series stage of resonator 817 is adjusted based on the magnitude of the current output of DAC 807.

In some embodiments, resonators 815 and 817 are implemented with tow-Thomas bi-quad tow-Thomas resonators. However, the resonators may have other configurations in other embodiments. In other embodiments, an ADC circuit may have a different number of resonators. Also in other embodiments, an ADC circuit may include capacitive feedback and feed forward capacitor paths (not shown).

As described herein, providing a last in series amplifier stage with a bias current that is controlled based on the magnitude of the output current of a feedback DAC may provide for an ADC circuit where the bias current for the last in series amplifier stage can track the DAC current to account for variation in temperature and process conditions. With some embodiments, the last in series stage would have sufficient current to maintain the signal and Q-noise feedback, there by maintaining signal-to-quantization noise ratio and minimizing distortion.

The ADC circuits shown and described herein may be used in a number of different applications such as e.g., networking applications and sensing applications for providing a digital indication of an analog signal in a number of different systems such as e.g., computers, cell phones, automotive electronics, wearables, IOT systems, industrial, embedded systems, or communications systems.

As used herein, one item is "coupled" to another item either by being connected to the other item or by being coupled in a current path or in a signal path through at least one further item. For example, in Figure 1, the output of ADC 103 is coupled to the input of DAC 105 through feedback circuit 153. The output of ADC 103 is coupled to feedback circuit 153 by being connected to its input. A gate is a control terminal of a FET. A drain and source are current terminals of a FET.

In one embodiment, an analog to digital converter (ADC) circuit includes an ADC including an output to produce a digital signal and a digital to analog converter (DAC) including an input coupled to the output of the ADC. The DAC including an output to provide an analog feedback signal. The ADC circuit includes a plurality of amplifier stages coupled in series, wherein a first in series amplifier stage of the plurality of amplifier stages includes an input to receive an error signal that is based on the analog feedback signal, wherein a last in series amplifier stage of the plurality of amplifier stages includes a bias current source whose current is controlled based on a magnitude of a current output of the DAC, wherein an earlier in series amplifier stage of the plurality of amplifier stages includes a corresponding bias current source whose current is characterized as a Proportional to Absolute Temperature (PTAT) current.

In a further embodiment, the ADC circuit includes a current control system that produces a control signal to control the current of the bias current source of the last in series amplifier stage of the plurality of amplifier stages, wherein a voltage of the control signal is controlled based on an amount of current drawn by a DAC replication circuit that is configured to simulate the magnitude of the current output of the DAC.

In a further embodiment of the ADC circuit, the bias current source of the last in series amplifier stage includes a first transistor, the current control system includes a second transistor coupled in series with the DAC replication circuit, the first transistor and the second transistor are configured in a current mirror configuration where the control signal is provided to a control terminal of the first transistor and provided to a control terminal of the second transistor.

In a further embodiment of the ADC circuit, the control signal is adjusted to maintain a node of a current path with the DAC replication circuit at a desired voltage.

In a further embodiment, the ADC circuit includes a current control system that produces a signal to control the current of the bias current source of the last in series amplifier stage of the plurality of amplifier stages, the current control system includes a DAC replication circuit that is configured to simulate a magnitude of the current output of the DAC, wherein the current provided by the bias current source is proportional to a current drawn by the DAC replication circuit.

In a further embodiment of the ADC circuit, each amplifier stage of the plurality of amplifier stages includes an operational transconductance amplifier.

In a further embodiment of the ADC circuit, each of all but the last in series amplifier stage of the plurality of amplifier stages includes bias current source whose current is characterized as a Proportional to Absolute Temperature (PTAT) current.

In a further embodiment, the ADC circuit includes a combiner circuit including a first input to receive an analog input signal and a second input to receive the analog feedback signal, wherein the combiner circuit produces the error signal by subtracting the analog feedback signal form the analog input signal.

In a further embodiment of the ADC circuit, the ADC is characterized as a delta sigma modulator ADC.

In a further embodiment of the ADC circuit, the plurality of amplifier stages is implemented in a delta sigma loop filter network of the ADC circuit.

In a further embodiment of the ADC circuit, the delta sigma loop filter network is a multi-order delta sigma loop filter network.

In a further embodiment, the ADC circuit includes a second plurality of amplifier stages coupled in series, wherein a first in series amplifier stage of the second plurality of amplifier stages includes an input coupled to an output of the plurality of amplifier stages coupled in series, wherein a last in series amplifier stage of the second plurality of amplifier stages includes a bias current source whose current is controlled based on the magnitude of the current output of the DAC, wherein an earlier in series amplifier stage of the second plurality of amplifier stages includes a corresponding bias current source whose current is characterized as a Proportional to Absolute Temperature (PTAT) current.

In a further embodiment of the ADC circuit, the plurality of amplifier stages has a greater number of amplifier stages than the second plurality of amplifier stages.

In a further embodiment, the ADC circuit includes a second DAC including an input coupled to the output of the ADC, the second DAC including an output to provide a second analog feedback signal, a second plurality of amplifier stages coupled in series, wherein a first in series amplifier stage of the second plurality of amplifier stages includes an input to receive a second error signal that is based on the second analog feedback signal, wherein a last in series amplifier stage of the second plurality of amplifier stages includes a bias current source whose current is controlled based on a magnitude of a current output of the second DAC, wherein an earlier in series amplifier stage of the second plurality of amplifier stages includes a corresponding bias current source whose current is characterized as a Proportional to Absolute Temperature (PTAT) current.

In a further embodiment of the ADC circuit, the plurality of amplifier stages are implemented in an integrator of the ADC circuit.

In a further embodiment of the ADC circuit, the plurality of amplifier stages are implemented in a resonator of the ADC circuit.

In another embodiment, a method of operating an analog to digital converter (ADC) circuit that includes an output to provide a digital signal, a digital to analog converter (DAC) that includes an output to provide an analog feedback signal that is an analog representation of the digital signal, and a plurality of amplifier stages coupled in series that includes an input to receive an error signal that is dependent on the analog feedback signal. The method includes producing a first bias current for a first in series amplifier stage of the plurality of amplifier stages wherein the first bias current is characterized as a PTAT current and producing a second bias current for a last in series amplifier stage of the plurality of amplifier stages, wherein the second bias current is controlled based on a magnitude of a current output of the DAC.

In a further embodiment of the method, the second bias current is proportional to a current drawn by a DAC replication circuit that is configured to simulate the magnitude of the current output of the DAC.

In a further embodiment of the method, the plurality of amplifier stages is implemented in a sigma delta modulator filter network of the ADC circuit.

In a further embodiment of the method, the plurality of amplifier stages is implemented in an integrator.

Features specifically shown or described with respect to one embodiment set forth herein may be implemented in other embodiments set forth herein.

## Claims

1. An analog to digital converter, ADC, circuit, comprising:
an ADC including an output to produce a digital signal;
a digital to analog converter, DAC, including an input coupled to the output of the ADC, the DAC including an output to provide an analog feedback signal;
a plurality of amplifier stages coupled in series, wherein a first in series amplifier stage of the plurality of amplifier stages includes an input to receive an error signal that is based on the analog feedback signal, wherein a last in series amplifier stage of the plurality of amplifier stages includes a bias current source whose current is controlled based on a magnitude of a current output of the DAC, wherein an earlier in series amplifier stage of the plurality of amplifier stages includes a corresponding bias current source whose current is characterized as a Proportional to Absolute Temperature (PTAT) current.

2. The ADC circuit of claim 1 further comprising:
a current control system that produces a control signal to control the current of the bias current source of the last in series amplifier stage of the plurality of amplifier stages, wherein a voltage of the control signal is controlled based on an amount of current drawn by a DAC replication circuit that is configured to simulate the magnitude of the current output of the DAC.

3. The ADC circuit of claim 2 wherein the bias current source of the last in series amplifier stage includes a first transistor, the current control system includes a second transistor coupled in series with the DAC replication circuit, the first transistor and the second transistor are configured in a current mirror configuration where the control signal is provided to a control terminal of the first transistor and provided to a control terminal of the second transistor.

4. The ADC circuit of claim 3 wherein the control signal is adjusted to maintain a node of a current path with the DAC replication circuit at a desired voltage.

5. The ADC circuit of any preceding claim further comprising:
a current control system that produces a signal to control the current of the bias current source of the last in series amplifier stage of the plurality of amplifier stages, the current control system includes a DAC replication circuit that is configured to simulate a magnitude of the current output of the DAC, wherein the current provided by the bias current source is proportional to a current drawn by the DAC replication circuit.

6. The ADC circuit of any preceding claim wherein each amplifier stage of the plurality of amplifier stages includes an operational transconductance amplifier.

7. The ADC circuit of any preceding claim wherein each of all but the last in series amplifier stage of the plurality of amplifier stages includes bias current source whose current is characterized as a Proportional to Absolute Temperature, PTAT, current.

8. The ADC circuit of any preceding claim further comprising:
a combiner circuit including a first input to receive an analog input signal and a second input to receive the analog feedback signal, wherein the combiner circuit produces the error signal by subtracting the analog feedback signal form the analog input signal.

9. The ADC circuit of any preceding claim wherein the ADC is characterized as a delta sigma modulator ADC.

10. The ADC circuit of claim 9 wherein the plurality of amplifier stages is implemented in a delta sigma loop filter network of the ADC circuit.

11. The ADC circuit of claim 10 wherein the delta sigma loop filter network is a multi-order delta sigma loop filter network.

12. The ADC circuit of any preceding claim further comprising a second plurality of amplifier stages coupled in series, wherein a first in series amplifier stage of the second plurality of amplifier stages includes an input coupled to an output of the plurality of amplifier stages coupled in series, wherein a last in series amplifier stage of the second plurality of amplifier stages includes a bias current source whose current is controlled based on the magnitude of the current output of the DAC, wherein an earlier in series amplifier stage of the second plurality of amplifier stages includes a corresponding bias current source whose current is characterized as a Proportional to Absolute Temperature, PTAT, current.

13. The ADC circuit of claim 12 wherein the plurality of amplifier stages has a greater number of amplifier stages than the second plurality of amplifier stages.

14. The ADC circuit of any preceding claim further comprising:
a second DAC including an input coupled to the output of the ADC, the second DAC including an output to provide a second analog feedback signal;
a second plurality of amplifier stages coupled in series, wherein a first in series amplifier stage of the second plurality of amplifier stages includes an input to receive a second error signal that is based on the second analog feedback signal, wherein a last in series amplifier stage of the second plurality of amplifier stages includes a bias current source whose current is controlled based on a magnitude of a current output of the second DAC, wherein an earlier in series amplifier stage of the second plurality of amplifier stages includes a corresponding bias current source whose current is characterized as a Proportional to Absolute Temperature (PTAT) current.

15. The ADC circuit of any preceding claim wherein the plurality of amplifier stages are implemented in an integrator of the ADC circuit.
